# EUROPEAN PATENT SPECIFICATION

(11) **EP 1 531 364 B1**
(45) Date of publication and mention of the grant of the patent: **17.07.2013**
(21) Application number: 04078004.1
(22) Date of filing: 02.11.2004
(51) Int. Cl.: G03F 7/20

(54) **Lithographic apparatus and device manufacturing method**
Lithographisches Gerät und Verfahren zur Herstellung einer Vorrichtung
Appareil lithographique et méthode de fabrication d'un dispositif

(30) Priority: 13.11.2003 WO PCT/NL03/00798; 16.12.2003 US 735847
(43) Date of publication of application: 18.05.2005
(73) Proprietor: ASML Netherlands B.V., 5504 DR Veldhoven (NL)
(72) Inventor: Bartray, Petrus Rutgerus, 5813 BR Ijsselsteijn (NL); Box, Wilhelmus Josephus, 3941 Eksel (BE); Kuit, Jan Jaap, 5508 RG Veldhoven (NL); Luijten, Carlo Cornelis Maria, 5525 BV Duizel (NL); Luttikhuis, Bernardus Antonius Johannes, 5673 KH Nuenen (NL); ten Bhomer, Michael, 5463 RH Veghel (NL); Migchelbrink, Ferdy, 3815 MD Amersfoort (NL)
(74) Representative: Corcoran, Gregory Martin Mason

(56) References cited:
- EP-A- 0 844 532
- EP-A- 1 178 357
- EP-A2- 1 341 044
- US-A- 5 137 349
- US-A- 6 118 599
- US-A1- 2003 112 445
- US-B1- 6 208 408
- US-B1- 6 529 264
- [Online] 17 October 2003 (2003-10-17), , XP002315395 Retrieved from the Internet: URL:http://web.archive.org/web/20031017235 432/http://www.engr.sjsu.edu/bjfurman/cour ses/ME250/ME250pdf/met_tool2-White.pdf> [retrieved on 2005-01-24] * page 5, paragraph 1; figure 2.1 * * page 11, paragraph 1 * * page 17, paragraph SUMMARY; table 4.4 *
- [Online] 2 October 2003 (2003-10-02), , XP002315396 Retrieved from the Internet: URL:http://web.archive.org/web/20031002212 412/http://www.handyharmancanada.com/TheBr azingBook/comparis.htm> [retrieved on 2005-01-24] * the whole document *
- GLEN A. SLACK AND S.F. BARTRAM: "thermal expansion of some diamondlike crystals" JOURNAL OF APPLIED PHYSICS, vol. 46, no. 1, January 1975 (1975-01), pages 89-98, XP002315394

## Description

The present invention relates to a lithographic apparatus and a device manufacturing method.
A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Lithographic apparatuses comprise a reference frame, which may also be referred as a metrology frame in the art. The reference frame provides support for the projection system. In certain types of conventional lithographic apparatus the reference frame is isolated from disturbances caused by other components of the lithographic apparatus, such as the long and short stroke motors used to drive the reticle and wafer stages. Reference frames are conventionally made from materials having a low coefficient of thermal expansion, such as alloys including Invar. Until now, it has been assumed that such materials having a low coefficient of thermal expansion are required in order to meet the thermal demands of the reference frame. Unfortunately, these materials are expensive resulting in a high manufacture cost. Furthermore, such materials are in limited supply and have a limited manufacturability. Operating in a dynamic market of supply and demand, these factors contribute to an unacceptably long lead time for the production of a reference frame. Such a long lead time also includes a large expense in terms of the man hours required to construct the reference frame due to the sub-optimal manufacturability of conventional reference frame materials. Due to problems in supply and demand of reference frames, it has been found that it is not possible to supply reference frames in sufficiently high volume in an upturn, thus losing output, and it is not possible to reduce output volume in a down turn, thus goods must remain in storage.

US 6208408 describes a projection exposure apparatus for exposure of a substrate, such as a wafer, for manufacture of semiconductor devices. The projection exposure apparatus includes a wafer stage for positioning a wafer, a projection lens disposed above the wafer stage, a reticle stage and a light source optical system. The light source optical system produces exposure light which passes a reticle placed on the reticle stage. The light is then collected by the projection lens onto the wafer, whereby a pattern of the reticle is transferred to the wafer. The wafer stage is supported at a base which is supported on the floor through an anti-vibration system. A cast frame is supported on the base. The position of the wafer stage is measured optically and without contact by means of a laser interferometer which is supported by the frame.

US 6 529 264 describes a projection exposure apparatus for transferring a pattern on a mask onto a substrate. The mask is held on a mask stage, whereas the wafer on which the mask pattern is to be transferred is held on a sample platform through a wafer holder. A laser interferometer is fastened to a column to continuously measure the positions of the sample platform and measuring the rotational angle of the sample platform as well. The measured values are sent to a controller of a stage drive. The linear motor is controlled for drive of the wafer stage in accordance with the measured values. In addition, a projection optical system is supported on a U-shaped column provided on a base. A multipoint autofocus sensor is provided at the side surface of the projection optical system to find the focus position and the angle of inclination of the surface of the wafer.

EP 1 341 044 describes a lithographic device comprising a mask table, a projection system, a substrate table which is displaceable relative to the projection system by means of a drive unit, and a measuring system for measuring a position of the substrate table relative to the projection system. A reference frame of the lithographic device is dynamically isolated from the machine frame by means of dynamic isolators. In this way it is prevented that vibrations caused in the machine frame by reaction forces of the drive unit are transmitted to the reference frame, so that the accuracy of the measuring system is not adversely affected by such vibrations.

It is an object of the present invention to provide an improved lithographic apparatus.

According to an aspect of the invention, there is provided a lithographic apparatus as claimed in claim 1.

The reference frame is provided with a thermal conditioning system for controlling the temperature of the projection system with respect to the reference frame. By providing such a thermal conditioning system, the long term thermal stability of the reference frame is improved. Further, after thermal drift of the reference frame and the optical system (caused for example by a service, maintenance or installation, etc) the thermal stabilization to reach the required performance is significantly reduced by active cooling. Another advantage is the improved thermal conditioning of the projection system provided with an actively conditioned reference frame.

By providing a reference frame comprising a material having a high coefficient of thermal expansion a wider variety of materials are available for the reference frame. It has been found that materials, such as aluminium or aluminium alloy materials, results in a significant cost of goods reduction and a significant lead-time decrease. Further, the additional surprising is achieved that the dynamic performance of the reference frame is equal or better than reference frames made of conventional materials, such as Invar. By rejecting the assumption that a reference frame must be constructed of a material having a low coefficient of thermal expansion in order to achieve the required thermal and thermodynamic performance, the inventors have overcome substantial technical prejudice.

In a preferred embodiment, said reference frame supports a measuring system for determining certain dimensions of said substrate prior to its exposure and said projection system.

Said coefficient of thermal expansion is greater than approximately 2.9x10⁻⁶/K. Surprisingly, it has been found that materials having a coefficient of thermal expansion greater than approximately 2.9x10⁻⁶/K, provide a reference frame having sufficient mechanical and thermal stability. It has been found that SiSiC, having a coefficient of thermal expansion of approximately 2.9x 10⁻⁶/K, is a material fulfilling these requirements.

In a preferred embodiment, the reference frame comprises anyone of the materials aluminium, aluminium alloy, titanium, iron, cast-iron, steel, stainless steel, copper, a ceramic material, concrete, granite, porcelain or combinations of these materials, for example, in a composite, sandwich or laminated structure. By using such materials the production costs of the reference frame are reduced. Further, an increase in design freedom is provided. The use of more versatile materials results in less technical production documentation with less mechanical development required for design changes in the reference frame and new frame designs. In particular, it has been found that aluminium or aluminium alloy, for example, are particularly dynamically robust

In a preferred embodiment, the reference frame comprises a solid block of material. By providing a reference frame in the form of a solid block, the manufacturability of the reference frame is further improved in contrast to conventional reference frames which may comprise a large number of casting or plate parts which require welding together. Further, a solid block provides a low internal thermal resistance and high thermal capacity. This results in only small temperature fluctuations from dynamic heat load variations and as a result small thermal drift of the reference frame.
In a preferred embodiment, the solid block is machined to form said reference frame. By machining a solid block, time consuming and expensive welding procedures are avoided.

In a preferred embodiment, the reference frame is provided with a highly infrared reflective surface. By providing the reference frame with a highly infrared reflective surface, the contamination risk is reduced, and/or the infrared reflection can be increased, and/or the friction coefficient can be enlarged. In particular, the surface may be provided in the form of a coating of a metal material of, for example, nickel. In a preferred embodiment, the reference frame is made of a material having a high specific heat and/or a high thermal conductivity. In particular, a material having a specific heat higher than about 600 J/(kgK) and/or said thermal conductivity higher than about 20 W/(m K).
By providing of reference frame of a material having a high specific heat and/or a high thermal conductivity, the thermal stability of the frame is improved.
In one embodiment, the reference frame is provided with a first temperature sensor for sensing a temperature of the reference frame.

In a further embodiment, the projection system comprises a projection lens, wherein said projection lens is provided with a second temperature sensor for sensing a temperature of said projection lens.

A further embodiment comprises a thermal conditioning system for thermally conditioning at least one of the reference frame and the projection system based on the temperatures sensed by at least one of the first and second temperature sensors. In this way both short and long term temperature fluctuations can be compensated for.

In a further embodiment, the thermal conditioning system comprises a control circuit for controlling an amount of heat transported to or from at least one of the reference frame and projection lens, a temperature regulating element and a heat transporting system, wherein the temperature regulating element regulates the amount of heat transported by said heat transporting system, wherein the heat transporting system is in thermal contact with at least one of the reference frame and the projection lens, for transporting heat to or from the at least one of said reference frame and the projection lens, wherein the control circuit is arranged to be responsive to the temperature sensed by at least one of the first and second temperature sensors, the temperature regulating element is responsive to the control circuit and is in thermal contact with the heat transporting system, so that a set temperature is reached in at least one of the reference frame and the projection lens. In this way, the temperature control of at least one of the reference frame and projection lens is improved.

In a further embodiment, the control circuit is arranged to take the temperature sensed by the first temperature sensor into account in compensating for a short term environmental temperature fluctuation. In this way the thermal stability of the apparatus is improved.

In a further embodiment, the control circuit is arranged to take the temperature sensed by the second temperature sensor into account in compensating for a long term environmental temperature fluctuation. In this way the thermal stability of the apparatus is further improved.

In a further embodiment, the thermal conditioning system comprises a single control loop for controlling the temperature of the reference frame and the projection lens. In this way both the long and short term environmental temperature fluctuations may be accounted for without adding significantly to the complexity and cost of the apparatus.

In a further embodiment, the heat transporting system comprises a conditioning fluid which is heated or cooled to said set temperature. In this way, the thermal conditioning system provides a versatile and effective temperature control of the apparatus.
According to a further aspect of the invention, there is provided a device manufacturing method as claimed in claim 15.
Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts details of a lithographic apparatus according to a further embodiment of the invention;
- Figure 3 depicts a top view of a reference frame isolated from a base frame according to an embodiment of the present invention showing certain components supported on the reference frame;
- Figure 4 depicts an underside view of the reference frame isolated from the base frame as shown in Figure 3;
- Figure 5 depicts details of a reference frame and a projection lens and a thermal conditioning system, and
- Figures 6-8 show results obtained.

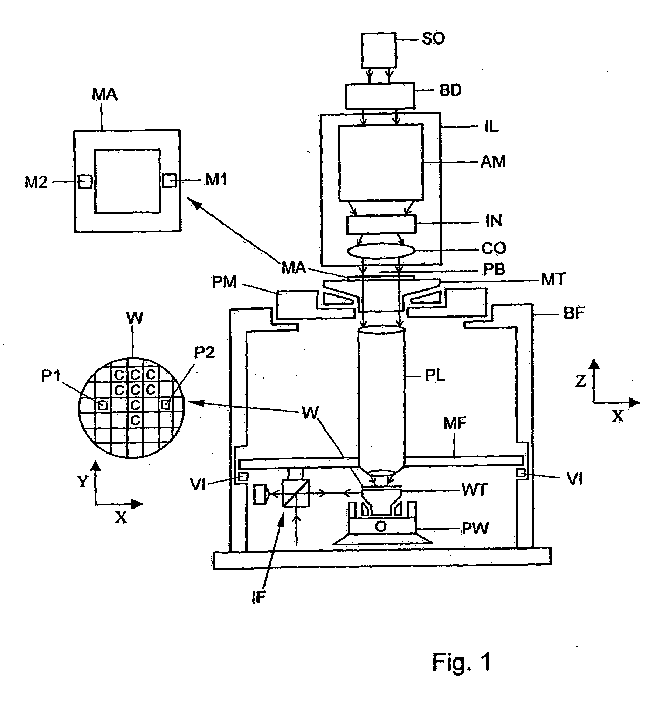

Figure 1 schematically depicts a lithographic apparatus according to a particular embodiment of the invention. The apparatus comprises:
- an illumination system (illuminator) II.. for providing a projection beam PB of radiation (e.g. UV radiation or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ -inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

Also shown in Figure 1 are two frames: a reference frame MF, which is also known as a so-called "metrology" frame, and a base frame BF. The reference frame MF provides a reference surface with respect to which the wafer is measured, and is mechanically isolated from the main apparatus structure. Typically, the reference frame MF is dynamically and thermally isolated. In particular, the reference frame MF is isolated from the base frame BF shown in Figure 1. The reference frame MF supports sensitive components such as the interferometer IF and other position sensors. Additionally, depending on the particular lithographic apparatus, the reference frame may also support the projections system PL. Further, the reference frame isolates those components supported thereon from vibration. Whilst the reference frame MF supports a metrology system, such as interferometer IF, and optionally also the projection system PL the base frame supports other components. In particular, the base frame BF supports a vibration isolation system VI for mechanically isolating the reference frame MF from the main apparatus structure. Additionally, and optionally, the base frame may support other components, such as the wafer stage WT (not shown in Figure 1) including the long stroke motor, and the reticle stage MT. In one embodiment, the base frame BF is in contact with the fabrication floor, alternatively, it is not. The vibration isolation system VI may be realised for example, as airmounts or other equivalent systems, such as a magnetic system, a mechanical system comprising low stiffness mechanical beams, or a fluid based system, which provide a resilient support for the reference frame MF with a low elastic coefficient, In a preferred embodiment, the vibration isolation system is disposed between the base frame BF and the reference frame RF. It is noted that the airmounts are suitable for use in a lithographic apparatus operating under a vacuum or atmospheric conditions.

The reference frame MF may be realised for example as a heavy table. According to the present invention, the reference frame MF is made of a material having a high coefficient of thermal expansion. Such materials may include, but are not limited to aluminium, aluminium alloy, titanium, iron, cast-iron, steel, stainless steel, copper, a ceramic material, concrete, granite, porcelain or combinations of these materials, for example, in a composite, sandwich or laminated structure. Table 1 shows some typical properties of some suitable construction materials are shown. Additionally, to aid comparision, values of the same properties are shown for Invar, which is a conventional material.

**Table 1**

| It is further noted that aluminium alloys have a coefficient of thermal expansion typically in the region or around 23 to 24.5 x10⁻⁶/K. | | | | | |
|---|---|---|---|---|---|
| Material | Coefficient of thermal expansion (x10⁻⁶/K) | Specific heat (J/(kg K)) | Thermal conductivity (W/(m K)) | Mass density (kg/m³) | Modules of elasticity (N/mm²) |
| Invar (conventional) | 1.5 | 500 | 13 | 8030 | 140000 |
| aluminium alloy (eg. AA5083 O) | 24 | 900 | 120 | 2660 | 71000 |
| steel (eg. Fe 360) | 12 | 460 | 57 | 7850 | 210000 |
| stainless steel (eg. 304(L) or 316(L)) | 16 | 500 | 16 | 7900 | 210000 |
| cast iron (eg. | 12 | 500 | 35 | 7100 | 170000 |
| GJS400-15) | | | | | |
| copper | 17 | 390 | 390 | 8900 | 120000 |
| ceramic material (eg. SiSiC) | 3 | 700 | 170 | 2950 | 410000 |
| porcelain | 2400 | 800 | 5 | 2400 | 104000 |
| granite | 2650 | 820 | 3.5 | 2650 | 30000 |

The reference frame MF is built up from a monolithic part, in other words a solid block. It may be cast or machined out of one block.

It has been found that a reference frame MF made in this way from aluminium, for example, has approximately the same mass as a conventional reference frame. Thus, its integration into the lithographic apparatus, in particular, with respect to its interface with the vibration isolation system VI, is very easily achieved. Further, it has been found surprisingly that the temperature environment around the reference frame is stable, which leads to an expected 2 nanometres drift over minutes for 5 metres,., which matches the tolerances achieved by conventional reference frame materials, such as Invar, which have a much lower coefficient of thermal expansion than those materials considered according to the present invention. It has been found that the dynamic performance of the reference frame made from materials which might be expected to exhibit poor dynamic performance due to their higher coefficient of thermal expansion, contrary to expectations exhibit a dynamic performance within those tolerances required in conventional lithographic apparatuses. Further, the centre of gravity can readily be adapted without sinificant influence on the dynamical performance. In one alternative embodiment, the reference frame MF is provided which is heavier than conventional reference frames. This is achieved, for example, by increasing its dimensions and/or by selecting a material, such as iron, which has a higher density. It has been found although such a heavier reference frame requires recalibration of the vibrational isolation system VI, it provides the further advantage that the dynamic performance of the reference frame MF is improved.
One suitable material is aluminium alloy of the type AA5083 (Al-4.4Mg-0.7Mn-0.15Cr). It is noted with respect to AA5083 or similar alloys, that it has the advantage that it has a very low internal stress level. This provides advantages in terms of machining a block of the material to form a reference frame MF and in terms of the long term stability of the reference frame.

It will be understood that, in addition, other aluminium based alloys may also be used., .
With respect to the specific heat and the thermal conductivity, it has been found that the specific heat is preferably higher than about 600 J(kgK) and/or the thermal conductivity is preferably higher than about 20 W/(m K).

Optionally, a cooling system may be incorporated either in or on the reference frame MF to improve the thermal stability. A fluid cooling system, such as water or air cooling, may be used to cool the reference structure. According to those embodiments, where the projection system PL is supported by the reference frame MF, the cooling system may be adapted in or on the reference frame to additionally cool the projection system.. In particular, a cooling system provides long term stability and provides short recovery time after thermal drift (for example, as experience after service, maintenance, installation, etc.).

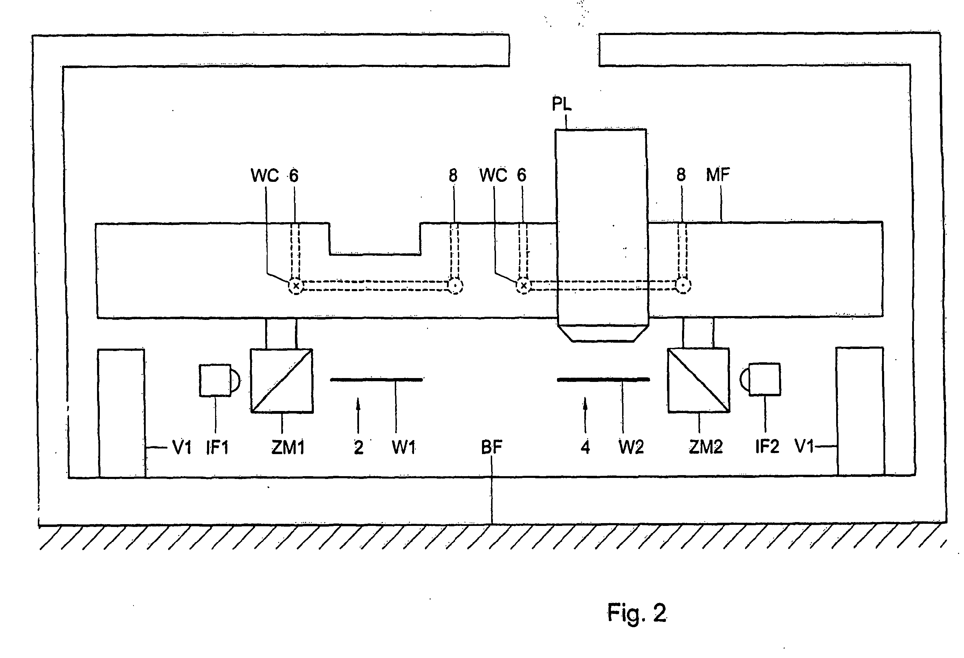

Figure 2 depicts details of a lithographic apparatus according to a further embodiment of the invention. In particular, Figure 2 shows a reference frame MF which is suitable for use in a TwinScan lithographic apparatus. A TwinScan apparatus allows measurement at a measurement station 2 of one substrate W1 prior to exposure whilst exposure at an exposure station 4 of a different substrate W2 takes place. Whilst the substrate W1 is in the measurement station 2, a first interferometer IF1 including a first Z-mirror ZM1 is provided to produce a "substrate map" of the substrate, that is the interferometer IF1 maps the contours of the substrates surface, so that in the exposure stage distortions in the surface of the substrate can be compensated for. Whilst the substrate W2 is at the exposure station 4, a second interferometer IF2 including a second Z-mirror ZM2 ensures that the "substrate map" produced in the measurement stage for substrate W2 is faithfully reproduced. In this particular embodiment, the reference frame MF supports both the metrology system IF and the projection system PL. In certain lithographic apparatuses, the reference frame MF may comprise a first reference frame portion on which the components providing measuring functionality are mounted and a second reference frame portion on which the components providing the exposure measuring functionality are mounted. These two frame portions are then typically mounted, for example, by bolting either to each other or to an additional mounting frame. In embodiments, where the reference frame comprises more than one frame portion, each frame portion may be provided with its own vibration isolation system, respectively. Alternatively, a single vibration isolation system may be provided. Figure 2 further shows an example of thermal conditioning system WC, for example, a cooling system, in particular a water cooling system WC which is formed in the reference frame MF. As shown, the reference frame MF is provided with ducts within the frame structure into which via inlets 6 a cooling liquid is introduced, and out of which via outlets 8 the cooling liquid leaves the structure. The ducts are formed so as to provide circulating cooling around that portion of the reference frame MF disposed opposite the measurement station 2 and exposure station 4, respectively. The cooling system includes one or more cooling circuits. In the particular embodiment shown in Figure 2, two cooling circuits are shown. In an alternative embodiment cooling may be provided by one cooling circuit. In a particular embodiment, a single cooling circuit may provide a cooling fluid to both the projection lens PL and the reference frame MF. The remaining components shown in Figure 2 correspond to those shown and described with respect to Figure 1 and are not described here further.

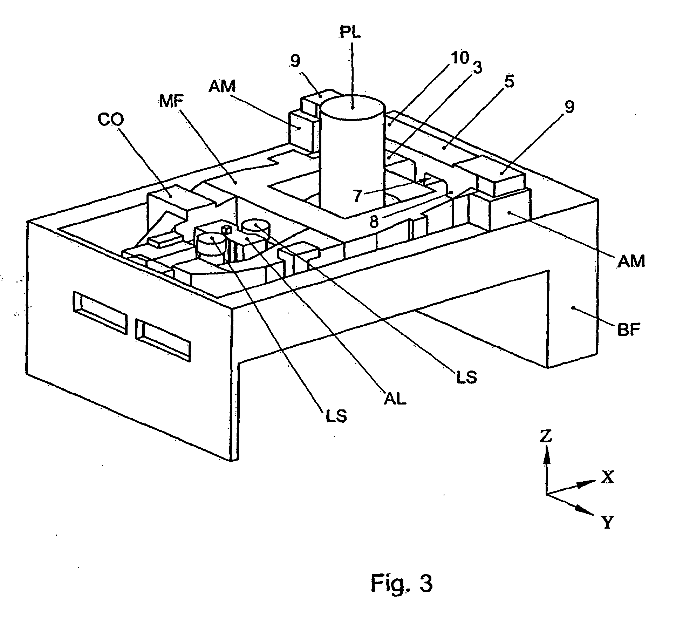

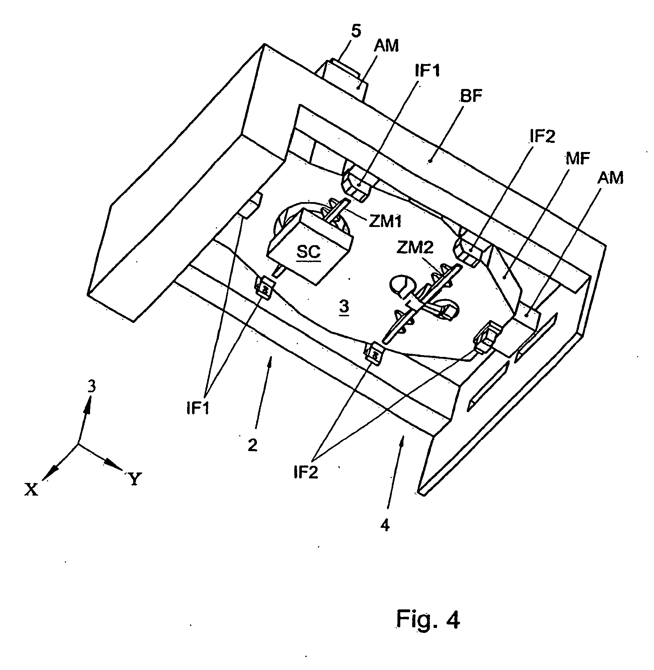

Figure 3 depicts a top view of a reference frame isolated from a base frame according to an embodiment of the present invention showing certain components supported on the reference frame MF. In particular, Figure 3 shows more detail with respect to the isolated relationship between the reference frame MF and the base frame BF and shows in greater detail the reference frame Mf and those components mounted thereon.
In the embodiment shown in Figure 3 the reference frame MF comprises a first portion 3 and a second portion 5, wherein the first portion and the second portion are machined from first and second blocks respectively. Alternatively, they may be cast. The first and second portions 3,5 cooperate with one another to form the reference frame MF. In particular, the first portion serves to support *inter alia* those components for carrying out the measuring stage and the exposing stage. For example, such components such as the projection lens PL, the level sensor module LS which senses the level of the substrate at the measuring position, the alignment module AL, which assesses the alignment of the substrate at the measuring position. Other components may be mounted on the underside of the reference frame MF. These are described and shown with reference to Figure 4. In the embodiment shown in Figure 3, the second portion 5 supports the vibration isolation system VI, which serves to isolate the reference frame MF from the base frame BF. It is in the form of a bridge wherein bridge support portions 7, 8 are disposed on the first portion 3. A portion 10 extending the length of the bridge is supported by bridge support portions 7, 8. At opposite ends 9 of the extending portion 10 are vibration isolation system supporting portions 9. The airmounts AM which form the vibration isolation system VI in Figure 3 are disposed between portions 9 and the base frame BF. Via the bridge 5, the vibration isolation from the base frame BF afforded by the airmounts AM is transferred to the components mounted on the first portion 3. In the embodiment shown in Figure 3, three airmounts are provided: one at either end of the bridge portion, a third (not shown in Figure 3, but shown in Figure 4), is disposed between the reference frame MF and the base frame BF at the opposite end in a longitudinal direction of the first portion of the reference frame MF. The invention, is not however, limited in this respect, and it will be understood that the vibration isolation system VI may be realised in a number of alternative ways, with respect both to the nature of the system and the number and arrangement of the system components.
In an alternative embodiment to that shown in Figure 3, the reference frame MF is comprises of a single portion, wherein the functionalities described above with respect to the first and second portion are combined into a single portion.
Also shown in Figure 3, the reference frame has a highly infrared reflective surface CO. This may be achieved by applying a coating to at least a part of the outer surface of the reference frame The coating covers the surface of the reference frame. It may cover at least the surface of a part of the reference frame MF. The coating is of a metal material such as nickel. Alternatively, a highly infrared reflective surface may be formed by polishing or surface treating the surface of the reference frame MF.

Figure 4 depicts an underside view of the reference frame MF isolated from the base frame BF as shown in Figure 3. In particular, those components mounted on the underside of the reference frame are shown. These include the interferometers IF1 arranged to carry out functions at the measuring station 2 and the interferometers IF2 arranged to carry out functions at the exposing station 4. Associated with each of these interferometers IF1, IF2 are associated Z-mirrors ZM1, ZM2, respectively. Also shown at the measuring station 2 is a substrate chuck SC which serves to support a substrate W. Once the measuring stage has been carried out, the substrate chuck SC moves from an aligned position with the measuring station 2 to an aligned position with respect to the exposing station 4. As mentioned previously, in one embodiment two substrate chucks are provided on which respective substrates are supported. The chucks are positioned and moved with respect to one another so that a first substrate may be measured at the measuring station 2 whilst a second substrate is exposed at the exposing station 4. Such an arrangement increases the throughput of substrates through the lithographic apparatus.
In addition, Figure 4 shows the vibrational isolation of the reference frame MF with respect to the base frame BF by virtue of a further airmount AM which is provided between part of the first portion 3 of the reference frame MF and the base frame BF. Also seen, is one of the airmounts AM mounted between the second portion 5 and the base frame BF.

It is desirable that the temperature control of the projection lens PL, the reference frame MF, interferometers IF and other sensors is at the milliKelvin level and below. For a reference frame MF made of a material such as aluminium, it is desirable that the temperature control is of the order of 0.1 mK/5 minutes. It is further desirable that the temperature stability of the environment of the projection lens PL, reference frame MF, interferometers IF and other sensors is in the order of 30 mK. It has been found that conventional lithographic apparatuses do not provide such temperature control.

In conventional lithographic apparatuses, a temperature sensor is provided only on the projection system. Only such a lens sensor is used for determination of the temperature set point for the thermal conditioning system for the supply of water in a lens circuit water cabinet (LCWC) and a motor circuit water circuit (MCWC) and air in an air control cabinet (ACC). Due to the large time constant and because of the thermal isolation of the lens, it has been found that the lens is insensitive to environmental temperature fluctuations. On the other hand, the reference frame MF and other temperature critical components are much more sensitive. Therefore, by sensing the temperature of the reference frame MF as well as the projection lens, both long term and short term fluctuations can be detected and accounted for. In one embodiment of the present invention, a reference frame MF of a material such as aluminium, which has a high coefficient of thermal expansion, the reference frame MF may be thermally conditioned, for example, with a water conditioning system. In a further embodiment, the reference frame MF is conditioned with the same water that conditions the projection system, in particular, the projection lens. Since the aluminium reference frame MF is more sensitive to environmental temperature fluctuations than a conventional reference frame, to compensate for a short term environmental temperature fluctuation, for example, the effect of actuator or a cover opening and closing, the temperature of the reference frame MF is sensed, and the temperature sensed is preferably used in the temperature control algorithm for compensation of the short term environmental temperature fluctuations. In a further embodiment, the temperature of the projection system PL is sensed with a sensor, for example, disposed on the projection lens, the temperature sensed is preferably used in combination with the temperature of the reference frame in the control algorithm for compensation of the long term environmental temperature fluctuations. It is desired to control the long term temperature of the apparatus, because the temperature of, in particular, the projection system is preferably to be kept stable at an operating temperature. A typical operating temperature being around 22 degrees Celcius. It has been found that both the long and short term temperature fluctuations may be controlled in a single control loop, as described in more detail below.

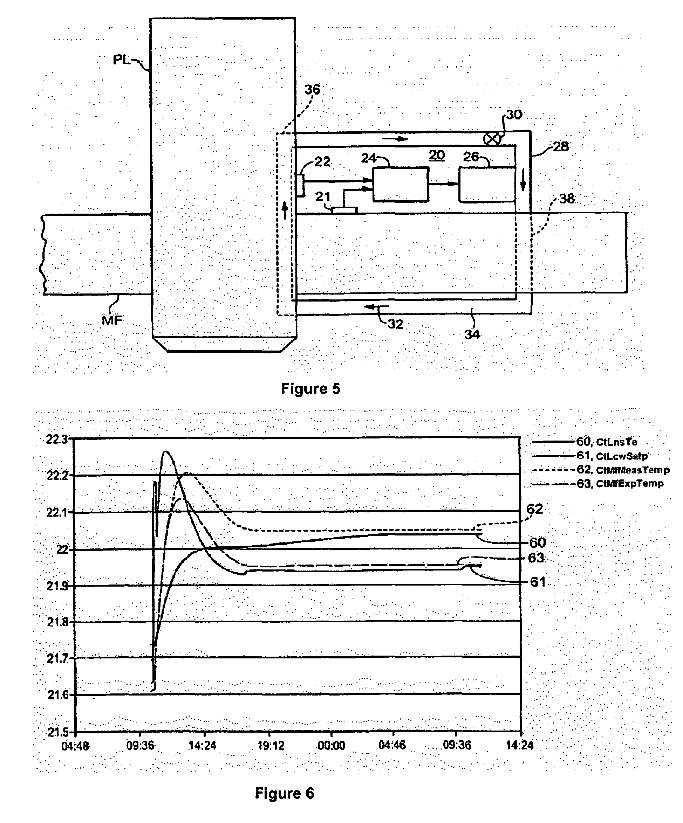

Figure 5 depicts details of a reference frame MF, a projection lens PL and a thermal conditioning system 20. By controlling the temperature of in particular, the reference frame MF and projection lens PL, the thermal stability of the lithographic apparatus is improved. In particular, by controlling the temperature of the reference frame having a high coefficient of thermal expansion, of a material, such as aluminium, the thermal stability of the frame is improved. Since a reference frame MF of aluminium is more sensitive to environmental temperature fluctuations than conventional reference frames made of invar.
In Figure 5 a control loop is used to regulate the temperature of at least one of the projection lens PL and the reference frame MF. In this embodiment at least one first temperature sensor 21 is provided for sensing a temperature of the reference frame MF. A further second temperature sensor 22 may be provided on the projection lens PL for sensing a temperature of the projection lens PL. The temperature sensors may comprise a device whose resistance is dependent on a temperature. The thermal conditioning system 20 is provided for controlling the temperature of at least one of the reference frame MF and the projection system PL based on the temperatures sensed by at least one of the first and second temperature sensors 21, 22. In one embodiment, the temperature of the reference frame MF and the projection lens PL are controlled on the basis of the temperatures sensed by both the first and second temperature sensors 21, 22. The thermal conditioning system 20 comprises a control circuit 24 for controlling an amount of heat transported to or from at least one of the reference frame MF and the projection lens PL. A temperature regulating element 26 is provided. The temperature regulating element 26 is arranged to heat and/or cool a fluid transported in a heat transporting system. The control circuit 24 is disposed between the temperature sensors 21, 22 and the temperature regulating element. The control circuit 24 is arranged to regulate the amount of heating so that a sensed temperature is regulated towards a set temperature. The control circuit 24 provides a control signal to the temperature regulating element 26 to control the heater and/or cooler depending on the control signal. The thermal conditioning system 20 further comprises a heat transporting system 28, 30, 32, 34, 36, 38. The temperature regulating element 26 is disposed in thermal contact with a heat transporting system 28, 30, 32, 34, 36, 38. The temperature regulating system 26 regulates the amount of heat transported by the heat transporting system 28, 30, 32, 34, 36, 38. The heat transporting system 28, 30, 32, 34, 36, 38 is further disposed in thermal contact with at least one of the reference frame MF and the projection lens PL, for transporting heat to or from the at least one of the reference frame MF and the projection lens PL. In particular, the heat transporting system 28, 30, 32, 34, 36, 38 comprises a supply duct 28, 36, 38 for supplying a conditioning medium 34 to the reference frame MF and the projection lens PL. The conditioning medium may be a fluid, such as water. The supply duct 28, 36, 38 is arranged to extend through portions of the reference frame MF and projection lens PL. In particular, the supply duct 38 comprises an enclosed channel formed in the reference frame MF, the supply duct 36 comprises an enclosed channel formed in the projection lens or projection system PL. The enclosed channels 36, 38 are arranged to extend within the reference frame MF and projection system PL so that they do not affect the functionality of these components. A circulation pump 30 is provided in the supply duct 28, 36, 38. In addition, or alternatively to the cooling element of the temperature regulating system 26, may be provided a cooling element (not shown) upstream of the temperature regulating system 26, arranged to remove excess heat from the conditioning medium 34. In Figure 5, one first and second temperature sensor 21, 22 are shown. In a further embodiment, a plurality of first temperature sensors and a plurality of second temperature sensors are provided. In this case, the average control circuit determines and regulates an average sensed temperature. The conditioning medium 34 may be cooled by a regulated amount instead of heated. In figure 5 the conditioning medium 34 is flowing sequentially through the reference frame MF and projection lens PL, in an alternative embodiment this flow can also be parallel towards the reference frame MF and the projection lens PL. In an alternative embodiment, a flow rate of the conditioning medium 34 may be regulated in order to control the heat transported by the heat transporting system. In a further alternative embodiment, rather than comprising a closed supply duct 28, as shown in Figure 5, the supply duct 28 may comprise an open pipe through which fresh conditioning medium is introduced. The heat transport system does not require that the conditioning medium be circulated through the system.

In particular, the control circuit 24 is arranged to be responsive to the temperature sensed by at least one of the first and second temperature sensors 21, 22, the temperature regulating element 26 is responsive to the control circuit 24 and is in thermal contact with the heat transporting system 28, 30, 32, 34, 36, 38 , so that a set temperature is reached in at least one of the reference frame MF and the projection lens PL. In a further particular embodiment, the control circuit 20 is arranged to take the temperature sensed by the first temperature sensor 21 into account in compensating for a short term environmental temperature fluctuation. In this way, short term temperature fluctuations, such as the effect of actuator, covers opening and closing can be compensated for. In particular, short term environmental temperature effects on the reference frame are compensated to prevent short term thermal drift of the frame and sensors. In a further embodiment, the control circuit 20 is arranged to take the temperature sensed by the second temperature sensor 22 into account in compensating for a long term environmental temperature fluctuation. In this way, the temperature of in particular, the projection lens PL is maintained at a constant temperature, since for consistent imaging quality, it is desirable that the projection lens PL be maintained at a constant reference temperature. In particular, the lens may be maintained at a reference temperature of, for example, 22 degrees Celcius. In one embodiment, the compensation of short and long term fluctuations is achieved in a single control loop. In a further embodiment, the heat transporting system 28, 30, 32, 34, 36, 38 transports heat to or from the reference frame MF and the projection lens PL. In this way, both the reference frame MF and projection lens PL are maintained at a predetermined set temperature without adding substantially to the complexity of the control of the lithographic apparatus. In one embodiment, a gas supply, such as an air shower, provides a gas to a location between the projection system PL and the substrate W, wherein a temperature of the gas supplied to the location is determined by the temperature of said conditioning fluid. Since the airshower temperature is determined by the lens cooling water as supplied by supply duct 36, a more thermally stable overall system is achieved.

Figures 6-8 show results obtained. In Figures 6-8, the trace 60 is the lens temperature (CtLnsTempFM), trace 61 is the temperature of the setpoint of the lens cooling water (CtLcsSetp), trace 62 is the temperature of the reference frame at the measure side (CtMfMeasTemp) and trace 63 is the temperature of the reference frame at the expose side (CtMtExpTemp).
Figure 6 shows experimental results achieved, in which the reference frame MF was aluminium. In particular, in Figure 6 the temperature recovery is achieved using the lens sensor 22 and during exposure of a substrate W the reference frame MF sensor 21 is used. It is seen that the long term drift of the lens PL is not corrected in this measurement. In a preferred embodiment both the sensor 21 which senses the temperature of the reference frame MF and the sensor 22 which senses the temperature of the projection lens PL are used in the control algorithm to prevent this long term lens temperature drift observed in Figure 6.

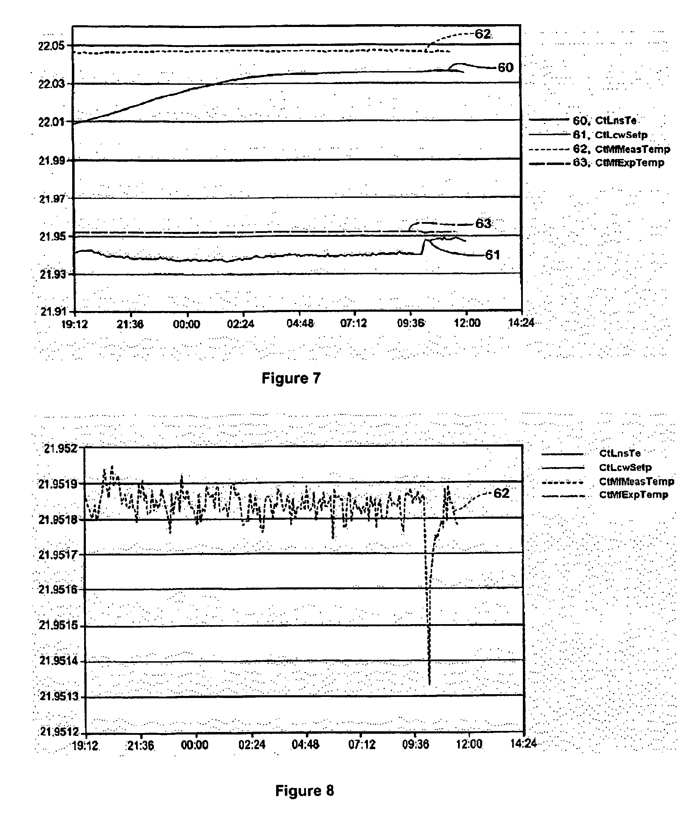

Figure 7 shows detail of the results shown in Figure 6. In particular, Figure 7 shows the results around the exposure phase. The correction for the short term experimental drift can be seen. At around 20.00h an exposure was started resulting in an environmental temperature increase of about 20 mK, this results in a temperature decrease of the LCW setpoint. Around 10.00h the covers were removed from the electronic cabinets resulting in a sudden decrease of the environmental air. This is accounted for by the control by a sudden temperature increase of the setpoint. As shown in Figure 7, the temperature of the reference frame MF is seen to remain stable.

Figure 8 shows detail of the results shown in Figure 6. In particular, Figure 8 shows the experimental results zoomed in at the reference frame MF temperature. It can be seen that at all times the temperature fluctuation are in the order of 0.1 mK, which corresponds to a measurement error of 1 nm, except when the covers are removed. It is commented that the removal of the covers can be regarded as an exceptional situation. Even then, the results shown in Figure 8 show that the recovery for this action is very quick. While specific embodiments of the invention have been described above, it will be appreciated that the invention may be practiced otherwise than as described. The description is not intended to limit the invention.

## Claims

1. A lithographic apparatus comprising:
- an illumination system (IL) for providing a projection beam (PB) of radiation;
- a support structure (MT) for supporting patterning means (MA), the patterning means (MA) serving to impart the projection beam (PB) with a pattern in its cross-section;
- a substrate table (WT) for holding a substrate (W);
- a projection system (PL) for projecting the patterned beam onto a target portion of the substrate (W); and
- an isolated reference frame (MF) for providing a reference surface with respect to which said substrate (W) is measured;
said reference frame (MF) comprising a material having a coefficient of thermal expansion which is greater than 2.9x10⁻⁶/K, **characterized in that** said reference frame (MF) is provided with a thermal conditioning system (20) for controlling the temperature of said projection system (PL) with respect to said reference frame (MF).

2. A lithographic apparatus according to claim 1, wherein said thermal conditioning system (20) conditions said reference frame (MF) and said projection system (PL) with a conditioning fluid.

3. A lithographic apparatus according to any preceding claim, wherein said reference frame (MF) is provided with a first temperature sensor (21) for sensing a temperature of said reference frame (MF).

4. A lithographic apparatus according to claim 3, wherein said projection system (PL) comprises a projection lens (PL), wherein said projection lens (PL) is provided with a second temperature sensor (22) for sensing a temperature of said projection lens (PL).

5. A lithographic apparatus according to claim 3 or 4, wherein the thermal conditioning system (20) is configured for thermally conditioning at least one of said reference frame (MF) and said projection system (PL) based on the temperatures sensed by at least one of said first and second temperature sensors (21, 22).

6. A lithographic apparatus according to claim 5 wherein said thermal conditioning system (20) comprises a control circuit (24) for controlling an amount of heat transported to or from at least one of said reference frame (MF) and projection lens (PL), a temperature regulating element (26) and a heat transporting system, wherein the temperature regulating element (26) regulates the amount of heat transported by said heat transporting system, wherein said heat transporting system is in thermal contact with at least one of said reference frame (MF) and said projection lens (PL), for transporting heat to or from said at least one of said reference frame (MF) and said projection lens (PL), wherein said control circuit (24) is arranged to be responsive to the temperature sensed
by at least one of said first and second temperature sensors (21, 22), said temperature regulating clement (26) is responsive to said control circuit (24) and is in thermal contact with said heat transporting system, so that a set temperature is reached in at least one of said reference frame (MF) and said projection lens (PL).

7. A lithographic apparatus according to claim 6, wherein said control circuit (24) is arranged to take the temperature sensed by said first temperature sensor (21) into account in compensating for a short term environmental temperature fluctuation.

8. A lithographic apparatus according to claim 6 or 7, wherein said control circuit (24) is , arranged to take the temperature sensed by said second temperature sensor (22) into account in compensating for a long term environmental temperature fluctuation.

9. A lithographic apparatus according to any of claims 6-8, wherein said heat transporting system transports heat to or from said reference frame (MF) and said projection lens (PL).

10. A lithographic apparatus according to any of claims 6-9, wherein said thermal conditioning system (20) comprises a single control loop for controlling the temperature of said reference frame (MF) and said projection lens (PL).

11. A lithographic apparatus according to any preceding claim, wherein said reference frame (MF) comprises any one of the materials aluminium, aluminium alloy, titanium, iron, cast-iron, steel, stainless steel, copper, a ceramic material, concrete, granite, porcelain or combinations of these materials, for example, in a composite, sandwich or laminated structure.

12. A lithographic apparatus according to any preceding claim, wherein said reference frame (MF) is provided with a infrared reflective surface (CO).

13. A lithographic apparatus according to claim 12, wherein said surface is provided by a coating of a metal, such as nickel.

14. A lithographic apparatus according to any preceding claim, wherein said reference frame (MF) is made of a material having a specific heat which is higher than 600 J/(kgk) and/or a thermal conductivity which is higher than 20 W/(mK).

15. A device manufacturing method comprising the steps of:
- providing a substrate (W);
- providing a projection beam (PB) of radiation using an illumination system (IL);
- using patterning means (MA) to impart the projection beam (PB) with a pattern in its cross-section; and
- projecting the patterned beam (PB) of radiation onto a target portion of the substrate (W),
- using an isolated reference frame (MF) to provide a reference surface with respect to which said substrate (W) is measured;
said reference frame (MF) comprises a material having a coefficient of thermal expansion which is greater than 2.9x10⁻⁶/K, **characterized in that** said reference frame (MF) is provided with a thermal conditioning system (20) for controlling the temperature of said projection system (PL) with respect to said reference frame (MF).

## Patentansprüche

1. Ein lithographisches Gerät, das Folgendes beinhaltet:
- ein Beleuchtungssystem (IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel (MA) dazu dient, den Projektionsstrahl (PB) in seinem Querschnitt mit einem Muster zu versehen;
- einen Substrattisch (WT) zum Halten eines Substrats (W);
- ein Projektionssystem (PL) zum Projizieren des gemusterten Strahls auf einen Zielabschnitt des Substrats (W); und
- einen isolierten Bezugsrahmen (MF) zum Bereitstellen einer Bezugsoberfläche, in Bezug auf welche das Substrat (W) gemessen wird;
wobei der Bezugsrahmen (MF) ein Material beinhaltet, das einen thermischen Ausdehnungskoeffizienten aufweist, welcher größer als 2,9 x 10⁻⁶/K ist, **dadurch gekennzeichnet, dass** der Bezugsrahmen (MF) mit einem thermischen Konditionierungssystem (20) versehen ist, um die Temperatur des Projektionssystems (PL) in Bezug auf den Bezugsrahmen (MF) zu regeln.

2. Lithographisches Gerät gemäß Anspruch 1, wobei das thermische Konditionierungssystem (20) den Bezugsrahmen (MF) und die Projektionslinse (PL) mit einem Konditionierungsfluid konditioniert.

3. Lithographisches Gerät gemäß einem der vorhergehenden Ansprüche, wobei der Bezugsrahmen (MF) mit einem ersten Temperatursensor (21) zum Wahrnehmen einer Temperatur des Bezugsrahmens (MF) versehen ist.

4. Lithographisches Gerät gemäß Anspruch 3, wobei das Projektionssystem (PL) eine Projektionslinse (PL) beinhaltet, wobei die Projektionslinse (PL) mit einem zweiten Temperatursensor (22) zum Wahrnehmen einer Temperatur der Projektionslinse (PL) versehen ist.

5. Lithographisches Gerät gemäß Anspruch 3 oder 4, wobei das thermische Konditionierungssystem (20) konfiguriert ist, um mindestens eines von dem Bezugsrahmen (MF) und dem Projektionssystem (PL) auf der Basis der von mindestens einem von dem ersten und zweiten Temperatursensor (21, 22) wahrgenommenen Temperaturen thermisch zu konditionieren.

6. Lithographisches Gerät gemäß Anspruch 5, wobei das thermische Konditionierungssystem (20) einen Regelkreis (24) zum Regeln einer Wärmemenge, die zu oder von mindestens einem von dem Bezugsrahmen (MF) und der Projektionslinse (PL) transportiert wird, ein temperaturregulierendes Element (26) und ein Wärmetransportsystem beinhaltet, wobei das temperaturregulierende Element (26) die Wärmemenge, die von dem Wärmetransportsystem transportiert wird, reguliert, wobei das Wärmetransportsystem mit mindestens einem von dem Bezugsrahmen (MF) und der Projektionslinse (PL) in thermischem Kontakt steht, um Wärme zu oder von dem mindestens einen von dem Bezugsrahmen (MF) und der Projektionslinse (PL) zu transportieren, wobei der Regelkreis (24) eingerichtet ist, um auf die von mindestens einem von dem ersten und zweiten Temperatursensor (21, 22) wahrgenommene Temperatur zu reagieren, wobei das temperaturregulierende Element (26) auf den Regelkreis (24) reagiert und mit dem Wärmetransportsystem in thermischem Kontakt steht, so dass in mindestens einem von dem Bezugsrahmen (MF) und der Projektionslinse (PL) eine festgesetzte Temperatur erreicht wird.

7. Lithographisches Gerät gemäß Anspruch 6, wobei der Regelkreis (24) eingerichtet ist, um die von dem ersten Temperatursensor (21) wahrgenommene Temperatur beim Kompensieren einer kurzfristigen Schwankung der Umgebungstemperatur zu berücksichtigen.

8. Lithographisches Gerät gemäß Anspruch 6 oder 7, wobei der Regelkreis (24) eingerichtet ist, um die von dem zweiten Temperatursensor (22) wahrgenommene Temperatur beim Kompensieren einer langfristigen Schwankung der Umgebungstemperatur zu berücksichtigen.

9. Lithographisches Gerät gemäß einem der Ansprüche 6-8, wobei das Wärmetransportsystem Wärme zu oder von dem Bezugsrahmen (MF) und der Projektionslinse (PL) transportiert.

10. Lithographisches Gerät gemäß einem der Ansprüche 6-9, wobei das thermische Konditionierungssystem (20) eine einzelne Regelschleife zum Regeln der Temperatur des Bezugsrahmens (MF) und der Projektionslinse (PL) beinhaltet.

11. Lithographisches Gerät gemäß einem der vorhergehenden Ansprüche, wobei der Bezugsrahmen (MF) ein beliebiges der Materialien Aluminium, Aluminiumlegierung, Titan, Eisen, Gusseisen, Stahl, Edelstahl, Kupfer, ein Keramikmaterial, Beton, Granit, Porzellan oder Kombinationen dieser Materialien, zum Beispiel in einer Verbund-, Schicht- oder Laminatstruktur, beinhaltet.

12. Lithographisches Gerät gemäß einem der vorhergehenden Ansprüche, wobei der Bezugsrahmen (MF) mit einer Infrarot reflektierenden Oberfläche (CO) versehen ist.

13. Lithographisches Gerät gemäß Anspruch 12, wobei die Oberfläche durch eine Beschichtung aus einem Metall wie etwa Nickel bereitgestellt wird.

14. Lithographisches Gerät gemäß einem der vorhergehenden Ansprüche, wobei der Bezugsrahmen (MF) aus einem Material gefertigt ist, das eine spezifische Wärme, die höher als 600 J/(kgK) ist, und/oder eine thermische Leitfähigkeit, die höher als 20 W/(mK) ist, aufweist.

15. Ein Verfahren zum Herstellen einer Vorrichtung, das die folgenden Schritte beinhaltet:
- Bereitstellen eines Substrats (W);
- Bereitstellen eines Projektionsstrahls (PB) aus Strahlung unter Verwendung eines Beleuchtungssystems (IL);
- Verwenden eines Musteraufbringungsmittels (MA), um den Projektionsstrahl (PB) in seinem Querschnitt mit einem Muster zu versehen; und
- Projizieren des gemusterten Strahls (PB) aus Strahlung auf einen Zielabschnitt des Substrats (W),
- Verwenden eines isolierten Bezugsrahmens (MF) zum Bereitstellen einer Bezugsoberfläche, in Bezug auf welche das Substrat (W) gemessen wird;
wobei der Bezugsrahmen (MF) ein Material beinhaltet, das einen thermischen Ausdehnungskoeffizienten aufweist, welcher größer als 2,9 x 10⁻⁶/K ist, **dadurch gekennzeichnet, dass** der Bezugsrahmen (MF) mit einem thermischen Konditionierungssystem (20) versehen ist, um die Temperatur des Projektionssystems (PL) in Bezug auf den Bezugsrahmen (MF) zu regeln.

## Revendications

1. Un appareil lithographique comprenant :
- un système d'illumination (IL) destiné à fournir un faisceau de projection (PB) de rayonnement ;
- une structure formant support (MT) destinée à supporter des moyens pour conformer selon un motif (MA), les moyens pour conformer selon un motif (MA) servant à conférer au faisceau de projection (PB) un motif dans sa coupe transversale ;
- une table porte-substrat (WT) destinée à porter un substrat (W);
- un système de projection (PL) destiné à projeter le faisceau à motif sur une portion cible du substrat (W) ; et
- un cadre de référence isolé (MF) destiné à fournir une surface de référence par rapport à laquelle ledit substrat (W) est mesuré ;
ledit cadre de référence (MF) comprenant un matériau possédant un coefficient de dilatation thermique qui est supérieur à 2,9x10⁻⁶/K, **caractérisé en ce que** ledit cadre de référence (MF) est muni d'un système de conditionnement thermique (20) destiné à contrôler la température dudit système de projection (PL) par rapport audit cadre de référence (MF).

2. Un appareil lithographique selon la revendication 1, dans lequel ledit système de conditionnement thermique (20) conditionne ledit cadre de référence (MF) et ledit objectif de projection (PL) à l'aide d'un fluide de conditionnement.

3. Un appareil lithographique selon n'importe quelle revendication précédente, dans lequel ledit cadre de référence (MF) est muni d'un premier capteur de température (21) destiné à capter une température dudit cadre de référence (MF).

4. Un appareil lithographique selon la revendication 3, dans lequel ledit système de projection (PL) comprend un objectif de projection (PL), ledit objectif de projection (PL) étant muni d'un deuxième capteur de température (22) destiné à capter une température dudit objectif de projection (PL).

5. Un appareil lithographique selon la revendication 3 ou la revendication 4, dans lequel le système de conditionnement thermique (20) est configuré pour conditionner thermiquement au moins un élément parmi ledit cadre de référence (MF) et ledit système de projection (PL) sur la base des températures captées par au moins un desdits premier et deuxième capteurs de température (21, 22).

6. Un appareil lithographique selon la revendication 5 dans lequel ledit système de conditionnement thermique (20) comprend un circuit de commande (24) destiné à contrôler une quantité de chaleur transportée vers ou à partir d'au moins un élément parmi ledit cadre de référence (MF) et ledit objectif de projection (PL), un élément de régulation de température (26) et un système de transport de chaleur, dans lequel l'élément de régulation de température (26) régule la quantité de chaleur transportée par ledit système de transport de chaleur, dans lequel ledit système de transport de chaleur est en contact thermique avec au moins un élément parmi ledit cadre de référence (MF) et ledit objectif de projection (PL), pour transporter de la chaleur vers ou à partir d'au moins un dit élément parmi ledit cadre de référence (MF) et ledit objectif de projection (PL), dans lequel ledit circuit de commande (24) est arrangé pour être sensible à la température captée par au moins un desdits premier et deuxième capteurs de température (21, 22), ledit élément de régulation de température (26) est sensible audit circuit de commande (24) et est en contact thermique avec ledit système de transport de chaleur, afin qu'une température de consigne soit atteinte dans au moins un élément parmi ledit cadre de référence (MF) et ledit objectif de projection (PL).

7. Un appareil lithographique selon la revendication 6, dans lequel ledit circuit de commande (24) est arrangé pour prendre en compte la température captée par ledit premier capteur de température (21) pour compenser une fluctuation de température ambiante à court terme.

8. Un appareil lithographique selon la revendication 6 ou la revendication 7, dans lequel ledit circuit de commande (24) est arrangé pour prendre en compte la température captée par ledit deuxième capteur de température (22) pour compenser une fluctuation de température ambiante à long terme.

9. Un appareil lithographique selon n'importe lesquelles des revendications 6 à 8, dans lequel ledit système de transport de chaleur transporte de la chaleur vers ledit ou à partir dudit cadre de référence (MF) et dudit objectif de projection (PL).

10. Un appareil lithographique selon n'importe lesquelles des revendications 6 à 9, dans lequel ledit système de conditionnement thermique (20) comprend une boucle de commande unique destinée à contrôler la température dudit cadre de référence (MF) et dudit objectif de projection (PL).

11. Un appareil lithographique selon n'importe quelle revendication précédente, dans lequel ledit cadre de référence (MF) comprend un matériau quelconque parmi l'aluminium, l'alliage d'aluminium, le titane, le fer, la fonte, l'acier, l'acier inoxydable, le cuivre, un matériau céramique, le béton, le granite, la porcelaine ou des combinaisons de ces matériaux, par exemple, dans une structure composite laminée ou sandwich.

12. Un appareil lithographique selon n'importe quelle revendication précédente, dans lequel ledit cadre de référence (MF) est muni d'une surface réfléchissante dans l'infrarouge (CO).

13. Un appareil lithographique selon la revendication 12, dans lequel ladite surface est fournie au moyen d'un revêtement en un métal, tel que du nickel.

14. Un appareil lithographique selon n'importe quelle revendication précédente, dans lequel ledit cadre de référence (MF) est réalisé en un matériau présentant une chaleur spécifique qui est supérieure à 600 J/(kg K) et/ou une conductivité thermique qui est supérieure à 20 W/(m K).

15. Un procédé de fabrication de dispositif comprenant les étapes consistant à :
- fournir un substrat (W) ;
- fournir un faisceau de projection (PB) de rayonnement à l'aide d'un système d'illumination (IL) ;
- utiliser des moyens pour conformer selon un motif (MA) pour conférer au faisceau de projection (PB) un motif dans sa coupe transversale ; et
- projeter le faisceau (PB) de rayonnement à motif sur une portion cible du substrat (W),
- utiliser un cadre de référence isolé (MF) pour fournir une surface de référence par rapport à laquelle ledit substrat (W) est mesuré ;
ledit cadre de référence (MF) comprenant un matériau possédant un coefficient de dilatation thermique qui est supérieur à 2,9x10⁻⁶/K, **caractérisé en ce que** ledit cadre de référence (MF) est muni d'un système de conditionnement thermique (20) destiné à contrôler la température dudit système de projection (PL) par rapport audit cadre de référence (MF).
